# EUROPEAN PATENT APPLICATION

(11) **EP 2 515 438 A1**
(43) Date of publication of application: **24.10.2012**
(21) Application number: 12177008.5
(22) Date of filing: 16.02.2010
(51) Int. Cl.: H03K 5/04, H03K 5/13, H03K 5/159, H03K 5/06

(54) **Pulse-Shrinking delay line based on feed forward**

(30) Priority: 17.02.2009 EP 09290114
(62) Divisional of application: 10705432.2
(71) Applicant: NXP B.V., 5656 AG Eindhoven (NL)
(72) Inventor: Crespo, Denis, 5656 AG Eindhoven (NL); Dufour, Yves, 5656 AG Eindhoven (NL); Marie, Herve, 5656 AG Eindhoven (NL)
(74) Representative: Schwarzweller, Thomas

(57) **Abstract**

The invention relates to an electronic circuit (600) comprising a digital delay line with a cascade of a plurality of stages (602,604,606) configured for modifying a width of a pulse propagating down the cascade, wherein each specific one of the stages has a first input (601,605,609), a second input (603,607,611), a first output (613,617,621) and a second output (615,619,623), a first inverter (606,610,614) between the first input and the first output; and a second inverter (608,612,616) between the second input and the second output. Each specific one of the stages has the first output connected to the second input of an adjacent one of the stages downstream in the cascade, and the second output connected to the first input of the adjacent one of the stages. Each specific stage (602,604,606) has a third inverter (618,622,626) connected between the first input (601,605,609) and the second input (611,603,607) of a downstream one of the stages in the cascade, and a fourth inverter (620,624,628) connected between the second input (603,607,611) and the first input (609,601,605) of the downstream one of the stages (606,602,604), and between the downstream one of the stages and the specific stage are connected an odd number of other ones of the stages.

## Description

### FIELD OF THE INVENTION

The invention relates to an electronic circuit comprising a digital delay line with a cascade of a plurality of stages configured for modifying a width of a pulse propagating down the cascade.

### BACKGROUND ART

Delay lines are well-known components and are used in, e.g., delay-locked loops (DLLs) and in time-to-digital converters (TDCs). DLLs are typically used for generating time-shifted clocks. The TDC is a key block for measuring timing differences between two clock signals. The TDC, in particular, is a key block of a digital PLL, such as the one needed in multi-gigahertz radio applications.

Digital delay lines are often made as a cascade of CMOS inverter stages. The binary signal propagates from the cascade's input to the cascade's output, and each stage delays the occurrence of the signal's edges by a specific amount of time.

In a TDC, the digital delay line used is typically of the type that changes the signal's pulse-width while the pulse is propagating along the cascade. This delay line has a cascade of stages, each of which implements a longer delay for the propagation of one of the pulses edges, e.g., the rising edge, than for the other edge of the pulse, e.g., the falling edge. This configuration shrinks or widens the width of the signal's pulse to a further extent at each stage. A stage is implemented as, e.g., a pair of CMOS inverters arranged in series. For an example of a known pulse-shrinking delay line see, e.g., Tisa S, Lotito A, Giudice A & Zappa F (2003) "Monolithic time-to-digital converter with 20ps resolution"; Proc. European Solid-State Circuits Conference, ESSCIRC'03, Estoril, Portugal, pp. 465-468.

There is a variety of approaches to obtaining a shrinking or widening of the pulse width. One approach is to select the ratios of the sizes of the transistors for the different stages so as to determine how fast a falling edge and how fast a rising edge propagates. For example, if the width of the p-type field effect transistor (FET) of the i-th inverter in the cascade is denoted by Wₚᵢ and the width of the n-type FET in the i-th inverter as Wₙᵢ; then shrinking occurs between the input of inverter₍ᵢ₎ and the output of inverter₍ᵢ₊₁₎ if the ratio Wₚ₍ᵢ₊₁₎/Wₙ₍ᵢ₊₁₎ is smaller than the ratio Wₚ₍ᵢ₎/Wₙ₍ᵢ₎. Another approach is to bias the gates of one or more transistor per stage. For more information see, e.g., US patent 6,288,587.

### SUMMARY OF THE INVENTION

The inventors propose an a pulse shrinking delay line, i.e., a delay line that modifies the signal's pulse width, with a configuration that enables to obtain a higher time resolution than the conventional pulse shrinking delay lines. That is, the delay line of the invention can be configured to operate with shorter delays.

More specifically, the invention relates to an electronic circuit comprising a digital delay line with a cascade of a plurality of stages configured for modifying a width of a pulse propagating down the cascade. Each specific one of the stages has a first input, a second input, a first output and a second output, a first inverter between the first input and the first output; and a second inverter between the second input and the second output. Each specific one of the stages has the first output connected to the second input of an adjacent one of the stages downstream in the cascade, and has the second output connected to the first input of the adjacent one of the stages. Each specific stage has a fifth inverter connected between the first input and the first input of a downstream one of the stages in the cascade, and a sixth inverter connected between the second input and the second input if the downstream one of the stages. The downstream stage is such that the downstream stage and the specific stage are connected via an odd number of other ones of the stages. A reason for this is explained as follows. The feed-forward path implements a single inversion between the nodes of the main path that are bridged by a feed-forward path's inverter. The main path of the cascade is formed by pairs of inverters that are cross-connected between succeeding stages. A snap shot of the logical states of the relevant nodes in the main path, taken at an arbitrary moment, reveals that the nodes bridged by the feed-forward path have assumed complementary logical states (e.g., one is high and the other is low) between the pulse's transitions. The feed-forward path, driven by a transition at a particular node upstream accelerates the complementary transition in the downstream node.

For completeness, a feed-forward mechanism in a delay line is mentioned in the description of Figs. 10 and 11 of US 2007/0047689. However, the delay line is not of the type that modifies the signal's pulse-width as the pulse is propagating down the delay line, and the specific connections are not detailed.

### BRIEF DESCRIPTION OF THE DRAWING

The invention is explained in further detail, by way of example and with reference to the accompanying drawings, wherein:
Fig. 1 depicts an embodiment of the invention;
Fig. 2 depicts a more detailed view of the invention.

Throughout the Figures, similar or corresponding features are indicated by same reference numerals.

### DETAILED EMBODIMENTS

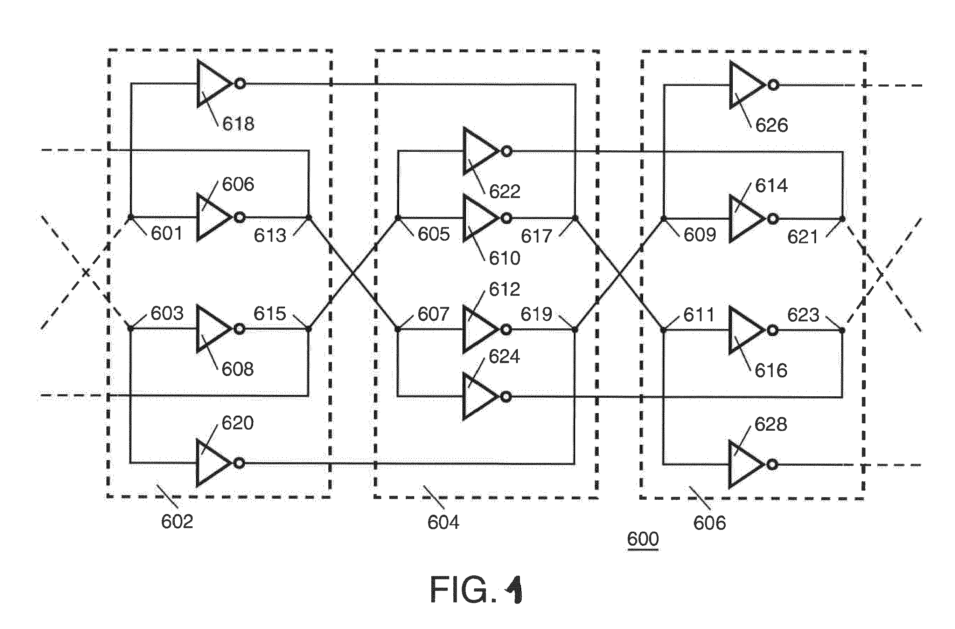

Fig.1 provides an embodiment of the invention in the form of a pseudo-differential delay line 600 with a plurality of stages in a cascade, of which only stages 602, 604 and 606 are shown. The main path through stages 602, 604 and 606 is formed by first inverter 606 and second inverter 608 in stage 602, first inverter 610 and second inverter 612 in stage 604, and first inverter 614 and second inverter 616 in stage 606. The main path of delay line 600 is similar to a pseudo differential delay line known in the art. That is, the sizes of the transistors in the relevant inverters are properly tuned to subject the pulse to a shrinking operation while propagating down the cascade.

Delay line 600 includes feed-forward paths according to the invention in order to pre-charge nodes further downstream in the cascade. The configuration is as follows. Each specific one of stages 602, 604 and 606 has a first input 601, 605 and 609, respectively; a second input 603, 607 and 611, respectively; a first output 613, 617 and 621, respectively; and a second output 615, 619 and 623, respectively. First inverters 606, 610 and 614 are connected between the first input and the first output of their respective stages. Second inverter 608, 612 and 616 are connected between the second input and the second output of their respective stages. Each of the stages, e.g., stage 604, has the first output, here output 617, connected to the second input of an adjacent one of the stages downstream in the cascade, here input 611 of stage 606. Each of the stages, e.g., stage 604, has its second output, here output 619, connected to the first input of the adjacent stage, here input 609 of stage 606. Each particular one of stages 602, 604 and 606 has a third inverter 618, 622 and 626, respectively, connected between the first input of the particular stage and the first input of a downstream one of the stages in the cascade. Each particular one of stages 602, 604 and 606 has a fourth inverter 620, 624 and 628, respectively, connected between the first input of the particular stage and the second input of the downstream one of the stages. Generally, there is an odd number of stages connected between the particular stage and the downstream stage. In the example shown, there is a single stage, e.g., stage 604, connected between the stages being connected through the feed-forward paths, here stages 602 and 606.

The inverters in delay line 600 can be implemented by full CMOS inverters, each having a P-FET and an N-FET with their main channels connected in series between the supply voltages.

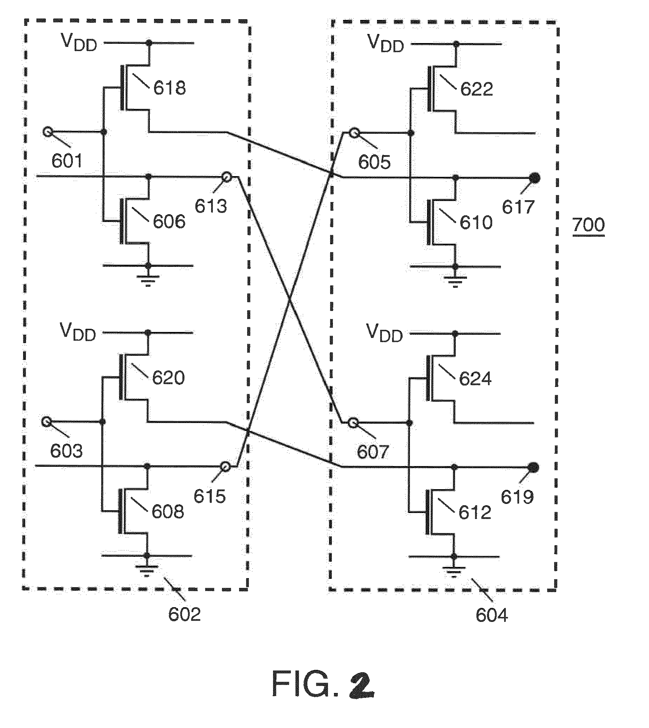

Fig. 2 is a diagram of an implementation 700 of delay line 600, wherein the full inverters have been replaced by single transistors. The best shrinking capability is obtained with lowest propagation time by omitting half the transistors: in the example shown, only the N-FETs are maintained in the main path, and the P-FETs are maintained in the feed-forward path. In Fig. 2, each transistor is indicated by the same reference numeral of the inverter in the diagram of Fig. 1 whose operation this transistor fulfills.
The inventors have carried out simulations for a shrinking-pulse delay line of cascaded stages with each a series connection of two conventional CMOS inverters, and for a shrinking-pulse delay line of cascaded stages each of which configured as implementation 300 made in a 65nm CMOS process for a supply voltage of 1.2 Volts at a temperature of 47° Celsius. The targeted shrinking delay Δt was set to 10 ps (10⁻¹¹ seconds). The delay TP_{H} per stage for a rising edge was found to be 33 ps for the conventional stage and 19 ps for the stage in the invention. The delay TP_{L} per stage for a falling edge was found to be 43 ps for the conventional stage and 29 ps for a stage in the invention.

Accordingly, in comparison to the conventional approach, the invention provides a shorter delay per stage, lower power consumption, and lower susceptibility of the operation to the transistor sizes used.

In above embodiments, the cascade of stages uses inverters. It is clear that other logic gates can be used that implement an inverting operation, e.g., a NOR gate or a NAND gate. These latter gates can be biased at one of their inputs so as to functionally implement an inverter, or the additional input terminals can be used to control the pulse propagating down the cascade by applying control signals thereto.

## Claims

1. An electronic circuit (600) comprising a digital delay line with a cascade of a plurality of stages (602, 604, 606) configured for modifying a width of a pulse propagating down the cascade, wherein:
- each specific one of the stages has a first input (601; 605; 609), a second input (603; 607; 611), a first output (613; 617; 621) and a second output (615; 619; 623), a first inverter (606; 610; 614) between the first input and the first output; and a second inverter (608; 612; 616) between the second input and the second output; the electronic circuit being **characterized in that**
- each specific one of the stages has the first output connected to the second input of an adjacent one of the stages downstream in the cascade, and the second output connected to the first input of the adjacent one of the stages;
- each specific stage (602, 604, 606) has a third inverter (618, 622, 626) connected between the first input (601, 605, 609) of the particular stage (602, 604, 606) and the second input (611, 603, 607) of a downstream one of the stages in the cascade, and a fourth inverter (620, 624, 628) connected between the second input (603, 607, 611) of the particular stage (602, 604, 606) and the first input (609, 601, 605) of the downstream one of the stages (606, 602, 604); and
- between the downstream one of the stages and the specific stage are connected an odd number of other ones of the stages.

2. The circuit of claim 1, wherein the odd number is unity.

3. The circuit of claim 1, wherein:
- the first inverter (606) is formed by a first transistor having its main channel connected between a first supply voltage and the first output, and having a control electrode connected to the first input;
- the second inverter (608) is formed by a second transistor having its main channel connected between the first supply voltage and the second output, and having its control electrode connected to the second input (603);
- the third inverter (618) is formed by a third transistor (618) having its main channel connected between a second supply voltage (VDD) and the first output (617) of the adjacent stage (604), and having its control electrode connected to the first input; and
- the fourth inverter (620) is formed by a fourth transistor (620) having its main channel connected between the second supply voltage (VDD) and the second output (619) of the adjacent stage (604), and having its control electrode connected to the second input.

4. The circuit of claim 3, wherein the first, second, third and fourth transistors have equal widths.
